# EUROPEAN PATENT SPECIFICATION

(11) **EP 4 289 550 B1**
(45) Date of publication and mention of the grant of the patent: **27.08.2025**
(21) Application number: 22842425.5
(22) Date of filing: 12.07.2022
(51) Int. Cl.: B23P 19/04, B23Q 11/14, B23Q 3/06, F16B 11/00, H10N 10/10, H01M 10/613, H01M 10/615, H01M 10/6572, H01M 50/204

(54) **BATTERY MODULE MANUFACTURING APPARATUS CAPABLE OF SWITCHING BETWEEN HEATING FUNCTION AND COOLING FUNCTION AND BATTERY MODULE MANUFACTURING METHOD USING THE SAME**
BATTERIEMODULHERSTELLUNGSVORRICHTUNG MIT FÄHIGKEIT ZUM UMSCHALTEN ZWISCHEN HEIZFUNKTION UND KÜHLFUNKTION SOWIE VERFAHREN ZUR HERSTELLUNG EINES BATTERIEMODULS DAMIT
APPAREIL DE FABRICATION DE MODULE DE BATTERIE CAPABLE DE COMMUTER ENTRE UNE FONCTION DE CHAUFFAGE ET UNE FONCTION DE REFROIDISSEMENT, ET PROCÉDÉ DE FABRICATION DE MODULE DE BATTERIE L'UTILISANT

(30) Priority: 14.07.2021 KR 20210092128
(43) Date of publication of application: 13.12.2023
(73) Proprietor: LG Energy Solution, Ltd., Seoul 07335 (KR)
(72) Inventor: PARK, Sung Kyu, Daejeon 34122 (KR)
(74) Representative: Plasseraud IP
(86) International application number: PCT/KR2022/010124
(87) International publication number: WO 2023/287163

(56) References cited:
- CN-A- 105 594 010
- CN-A- 112 186 073
- DE-T5- 112010 001 156
- JP-A- 2016 187 013
- JP-A- 2016 187 013
- KR-A- 20120 096 322
- KR-A- 20190 075 898
- KR-A- 20190 075 898
- KR-B1- 101 209 705
- US-B2- 10 566 481

## Description

### [Technical Field]

This application claims the benefit of priority to Korean Patent Application No. 2021-0092128 filed on July 14, 2021.

The present invention relates to a battery module manufacturing apparatus and a manufacturing method using the same, and more particularly to a battery module manufacturing apparatus including a temperature convertor capable of switching between a heating function and a cooling function, thereby improving production efficiency, and a battery module manufacturing method using the same.

### [Background Art]

With increasing demand for portable electronic devices, such as a smartphone, a tablet, and a laptop computer, demand for secondary batteries as energy sources thereof has also abruptly increased. Thereamong, a lithium secondary battery, which has high energy density and a long battery lifespan, has been most widely used.

The lithium secondary battery includes an electrode assembly configured such that a positive electrode plate having a positive electrode active material applied thereto and a negative electrode plate having a negative electrode active material applied thereto are disposed in the state in which a separator is interposed therebetween and a battery case in which the electrode assembly is received together with an electrolytic solution in a hermetically sealed state. In general, the lithium secondary battery may be classified as a can-shaped secondary battery having an electrode assembly mounted in a metal can or a pouch-shaped secondary battery having an electrode assembly mounted in a pouch made of an aluminum laminate sheet based on the shape of a sheathing member.

The lithium secondary battery is mounted in a module case in the state in which an electric connection member and a safety member are connected to the lithium secondary battery and is fixed by a reversible or irreversible fixing means, whereby the lithium secondary battery is manufactured as a battery module. A battery module manufacturing process is performed by automated equipment, and generally includes unit processes, such as fixation of battery cells, cooling of a battery module, and end-of-life (EOL) inspection of the manufactured battery module. Since the respective processes are performed while the battery module is moved to respective process positions, there is a problem in that overall configuration of processes is complicated and total production time is long.

In particular, an adhesive for structures used to manufacture the battery module needs about 24 hours to completely harden at room temperature. Accordingly, the battery module is manufactured through a high-temperature hardening method using a high-temperature hardening apparatus in order to reduce processing time. In addition, a separate cooling apparatus is used in order to uniformly cool the battery module before EOL inspection, or inspection is performed after the battery module is left for a predetermined time so as to be cooled.

A conventional battery module manufacturing process is performed in a manner in which glue is applied to a module assembly jig, cells are inserted, components are assembled, and high-temperature hardening is performed in a high-temperature hardener for a predetermined time. In this process, however, hardening time is long, and there occurs temperature deviation between the cells. In addition, when the next manufacturing process is completed after high-temperature hardening, a separate cooling process for eliminating the temperature deviation is necessary for EOL inspection. If the separate cooling process is added in order to uniformly cool the battery module, as described above, the manufacturing process time is lengthened, and a congestion section occurs in the overall process, whereby the overall production process is delayed.

Patent Document 1 relates to a battery pack manufacturing apparatus that couples a pack case in the state in which battery cells are mounted, specifically an apparatus configured such that, in the state in which a product to be processed is located on a lower jig member, the product is pressed by an upper jig member that is operated by pressure of a press such that the product is processed. The press is installed at an upper end part of a frame of the apparatus, the upper jig member is installed at the frame by a tension spring, a sensing unit configured to detect pressing force from the press is installed on the upper jig member, and the pressure applied by the press is adjusted based on the pressure detected by the sensing unit.

Patent Document 2 discloses a battery pack manufacturing method using a receptor configured to receive a plurality of cells, a plate cover configured to close one surface of the receptor, and a mounting bolt configured to mount the cover to an intermediate member, wherein the receptor is provided with battery cell holders, an adhesive is injected into the battery cell holders between outer circumferential surfaces of the battery cells and inner circumferential surfaces of the battery cell holders in order to fix the battery cells in the battery cell holders.

Patent Document 3 discloses a battery module manufacturing method of adding a thermosetting and ultraviolet-setting adhesive to an inner surface of a receiving portion having a plurality of hollow structures formed in a module housing, mounting cylindrical battery cells in the receiving portion, applying heat to the adhesive in order to reduce viscosity of the adhesive, and irradiating the adhesive with ultraviolet light in order to finally harden the adhesive such that the cylindrical battery cells are fixed to the module housing.

However, Patent Document 1 to Patent Document 3, each of which relates to a battery module manufacturing apparatus or a battery module manufacturing method, do not consider the fact that hardening and cooling processes are constituted as separate processes, whereby the overall process time is increased, and therefore process efficiency is affected.

Therefore, technology related to a battery module manufacturing apparatus capable of switching between a heating function and a cooling function, which is recognized to be an important problem in the present invention, thereby reducing adhesive hardening time necessary to fix battery cells and performing immediate cooling without movement to another process, and therefore it is possible to improve overall process efficiency and to secure productivity, has not yet been proposed.

### (Prior Art Documents)

(Patent Document 1) Korean Registered Patent Publication No. 10-0884942
(Patent Document 2) Japanese Patent Application Publication No. 2019-102353
(Patent Document 3) Korean Registered Patent Publication No. 10-2090255

Further background art is described JP 2016-187013 A, KR 2019-0075898 A, DE 11 2010 001156 T6, KR 2012-096322 A, and CN 112186073 A.

### [Disclosure]

### [Technical Problem]

The present invention has been made in view of the above problems, and it is an object of the present invention to provide a battery module manufacturing apparatus that is capable of switching between a heating function and a cooling function in a single apparatus, is capable of reducing hardening time, and performs no further cooling process, thereby improving production efficiency.

### [Technical Solution]

A battery module manufacturing apparatus according to the present invention to accomplish the above object is according to claim 1 and includes a pressing jig (100) and a base jig (200) located under the pressing jig (100), wherein the base jig (200) includes a temperature convertor capable of switching between a heating function and a cooling function.

The temperature convertor includes a thermoelectric device (220), and the thermoelectric device (220) may heat or cool a battery module (300) located at an upper end of the base jig (200) by changing a direction in which current is supplied.

The thermoelectric device may be a Peltier element.

A thermal pad (210) may be located at an upper end of the thermoelectric device (220).

A cooler may be located at a lower end of the thermoelectric device (220).

The cooler may include a cooling fin (230).

The cooler may include one or more cooling fans (240) located at a lower end part of the cooling fin (230).

A temperature sensor (250) electrically connected to a controller may be located at the temperature convertor, and the controller may control the temperature of the temperature convertor using received temperature data.

In addition, the present invention provides a battery module manufacturing method according to claim 8 which includes (s1) setting a heat transfer plate on a base jig, (s2) disposing a module housing at an upper end of the heat transfer plate, (s3) applying an adhesive to the interior of a battery cell receiving portion of the module housing, (s4) disposing a battery cell in the battery cell receiving portion and assembling components, (s5) heating an upper end surface of the base jig, and (s6) cooling the upper end surface of the base jig.

The battery module manufacturing method may further include preheating the module housing in step (s2).

A direction in which current is supplied to a thermoelectric device located at the base jig may be changed to perform the heating in step (s5) and to perform the cooling in step (s6).

In addition, the present invention provides a battery module produced by the battery module manufacturing method according to the present invention.

In addition, the present invention may provide various combinations of the above solving means.

### [Advantageous Effects]

As is apparent from the above description, in a battery module manufacturing apparatus according to the present invention, it is possible to switch between a heating function and a cooling function in a single apparatus, whereby it is possible to simplify the configuration of a process, to improve overall production efficiency, and to reduce manufacturing cost.

No further cooling process is necessary, whereby it is possible to prevent movement of a battery module or application of impact to the battery module while the battery module is transferred to the cooling process, and therefore it is possible to improve quality of the battery module.

### [Description of Drawings]

FIG. 1 is an exploded perspective view of a battery module manufacturing apparatus according to an embodiment of the present invention.
FIG. 2 is a perspective view of a base jig and a pressing jig configured to press a battery module.
FIG. 3 is a sectional view of the base jig taken along line A-A' of FIG. 1.
FIG. 4 is a schematic view of a battery module according to an embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

In addition, a description to embody elements through limitation or addition may be applied to all inventions, unless particularly restricted, and does not limit a specific invention.

Also, in the description of the invention and the claims of the present application, singular forms are intended to include plural forms unless mentioned otherwise.

Also, in the description of the invention and the claims of the present application, "or" includes "and" unless mentioned otherwise. Therefore, "including A or B" means three cases, namely, the case including A, the case including B, and the case including A and B.

In addition, all numeric ranges include the lowest value, the highest value, and all intermediate values therebetween unless the context clearly indicates otherwise.

Hereinafter, a coating apparatus according to the present invention will be described with reference to the accompanying drawings.

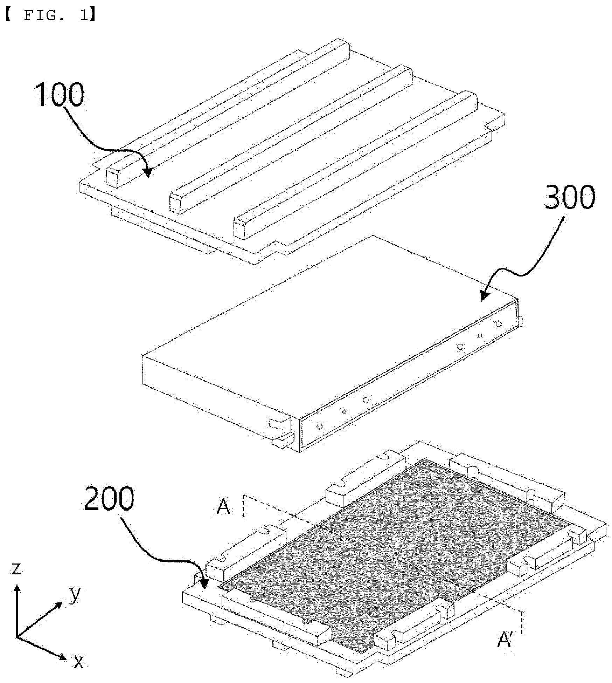

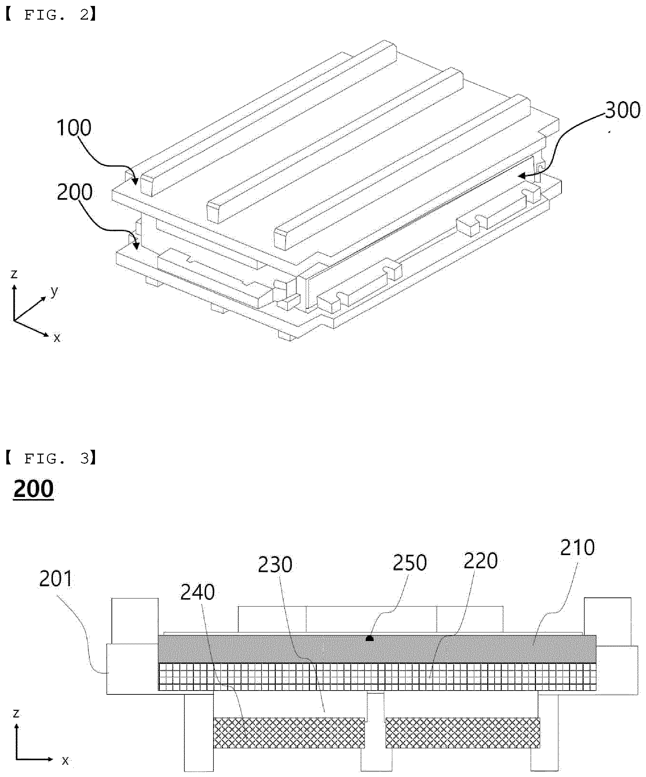

FIG. 1 is an exploded perspective view of a battery module manufacturing apparatus according to an embodiment of the present invention, FIG. 2 is a perspective view of a base jig and a pressing jig configured to press a battery module, and FIG. 3 is a sectional view of the base jig taken along line A-A' of FIG. 1.

When describing the battery module manufacturing apparatus according to the embodiment of the present invention with reference to FIGS. 1 to 3, the battery module manufacturing apparatus includes a pressing jig 100 and a base jig 200.

When describing the base jig 200 in detail first, the base jig 200 may include a base jig frame 201, a mounting portion (not shown) configured to allow a battery module 300 to be mounted to an upper end surface thereof, and a supporting portion (not shown) configured to support the battery module 300 mounted to the mounting portion so as not to move leftwards, rightwards, forwards, and rearwards.

The mounting portion of the base jig 200 may form a horizontal plane and may include a thermal pad 210 that faces a lower end surface of the battery module 300 located at the upper end of the mounting portion, and a thermoelectric device 220 may be disposed at a lower end of the thermal pad 210.

The thermal pad 210 may efficiently transfer heat.

In the present invention, when ends of two kinds of metals are connected to each other and current flows therethrough, one terminal of the thermoelectric device 220 constitutes a low temperature portion configured to perform an endothermic operation and the other terminal of the thermoelectric device constitutes a high temperature portion configured to perform an exothermic operation depending on the direction in which current flows. That is, when the direction in which current flows in the thermoelectric device 220 is changed, the low temperature portion and the high temperature portion of the thermoelectric device 220 are switched.

The thermoelectric device portion 220 includes a thermoelectric element, such as a Peltier element. When ends of two kinds of metals are connected to each other and current flows therethrough, one terminal of the thermoelectric element constitutes a low temperature portion configured to perform an endothermic operation and the other terminal of the thermoelectric element constitutes a high temperature portion configured to perform an exothermic operation depending on the direction in which current flows. At this time, when semiconductors having different electric conduction modes, such as bismuth (Bi) and tellurium (Te), are used instead of the two kinds of metals, it is possible to obtain a Peltier element capable of performing an endothermic operation and an exothermic operation with high efficiency.

When electric power is supplied to the thermoelectric device 220, the endothermic operation or the exothermic operation is performed toward an upper part or a lower part of the thermoelectric device 220 depending on the direction in which the electric power is supplied.

First, heating and cooling processes of the base jig 200 will be described.

When electric power is supplied, the endothermic operation is performed at the lower part of the thermoelectric device 220, and the exothermic operation is performed at the upper part of the thermoelectric device, the battery module 300 abutting the upper part of the thermoelectric device 220 is heated. Conversely, when the exothermic operation is performed at the lower part of the thermoelectric device 220, and the endothermic operation is performed at the upper part of the thermoelectric device, the battery module 300 abutting the upper part of the thermoelectric device 220 is cooled.

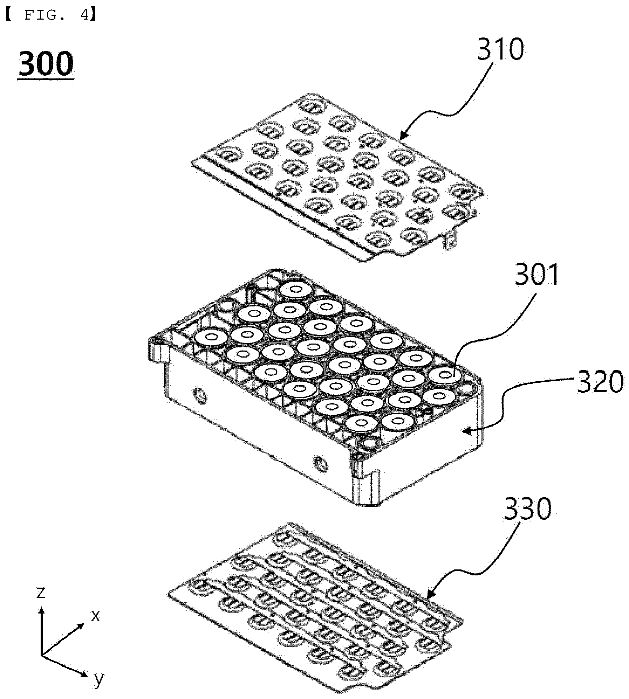

When the endothermic operation is performed at the lower part of the thermoelectric device 220 and the exothermic operation is performed at the upper part of the thermoelectric device, heat generated from the upper part of the thermoelectric device 220 may be effectively transferred to the battery module 300 located at the upper end of the thermal pad 210 through a wide surface of the thermal pad located at the upper part of the thermoelectric device 220. In addition, the battery module 300 located at the upper end of the base jig 200 may be heated, battery cells 301, a description of which will follow, in the battery module 300 may be effectively adhered to a module housing 320, a description of which will follow. The battery module 300 will be described in detail below with reference to FIG. 4.

Meanwhile, although not shown in the drawings, an electric power supply unit and a temperature display unit of the thermoelectric device 220 may be included, and a controller configured to control the supply of electric power and current direction switching may be included.

When the endothermic operation is performed at the upper part of the thermoelectric device 220 and the exothermic operation is performed at the lower part of the thermoelectric device, heat generated from the lower part of the thermoelectric device 220 may be dissipated by a heat dissipation means abutting the lower part of the thermoelectric device 220. Here, the heat dissipation means may include a cooling fin 230 and a cooling fan 240. The cooling fin 230 may be located at a lower end part of the thermoelectric device 220, and may be located so as to correspond to the entirety of the horizontal plane of the mounting portion (not shown) of the base jig 300. In addition, at least one cooling fan 240 may be located at a lower end part of the cooling fin 230.

Heat generated at the lower part of the thermoelectric device 220 may be transferred to the cooling fin 230, and the heat may be effectively discharged to the outside through the cooling fan 240 located at the lower end part of the cooling fin 230.

At the same time, the battery module 300 abutting the upper part of the thermoelectric device 220 may be cooled, since the endothermic operation is performed at the upper part of the thermoelectric device 220.

Also, in the present invention, the base jig 200 may be provided with at least one temperature sensor 250. The temperature sensor 250 may be a thermistor. The temperature sensor 250 may be located at the mounting portion (not shown) of the base jig 200, on which the battery module 300 is disposed, and specifically may be located in the thermal pad 210 layer or may be located so as to protrude above the thermal pad 210 and may be disposed so as to contact a surface of a heat transfer plate (not shown) disposed at the upper end surface of the mounting portion to mount the battery module 300. The temperature sensor 250 may measure the temperature of a contact part between the battery module 300 and the mounting portion of the base jig 200, and may transmit the measured temperature to a controller (not shown).

In the present invention, the heat transfer plate is disposed at the upper end surface of the mounting portion so as to support the battery module 300 located at the upper end of the mounting portion and to prevent damage to the thermal pad 210, the thermoelectric device 220, and the temperature sensor 250 located at the mounting portion. In addition, the heat transfer plate may be an aluminum plate or a heat sink, which is advantageous to smooth heat transfer between the mounting portion of the base jig 200 and the battery module 300.

The thermoelectric device 220 may be formed by joining two different kinds of metal plates having good electrical conductivity, a P-type semiconductor P configured to conduct electricity by holes, and an N-type semiconductor N configured to conduct electricity by electrons to each other, the semiconductors being disposed between the two kinds of metal plates. When electric power is applied to the thermoelectric device 220 through the controller (not shown), the thermoelectric device 220 heats or cools the different metal plates depending on the direction in which current of the applied electric power flows.

The base jig 200 according to the present invention may further include a controller (not shown). When a heating function or a cooling function is set through the controller, electric power supplied from a power supply unit (not shown) is provided to a driving portion (not shown) of the thermoelectric device 220 according to the setting. The driving portion of the thermoelectric device 220 supplies the electric power supplied thereto to the thermoelectric device 220 to heat or cool the battery module 300 located at the mounting portion of the base jig 200 according to a control signal of the controller.

In addition, a heating or cooling target temperature of the battery module 300 may be preset through the controller (not shown), and the controller may control driving of the thermoelectric device 220 based on the temperature sensed by the temperature sensor 250. That is, when the preset temperature is reached, the supply of electric power to the thermoelectric device 220 may be interrupted, whereby it is possible to temporarily stop the heating or cooling function.

Next, the pressing jig 100 will be described.

In the present invention, the pressing jig 100 may be located at an upper part of the base jig 200. In addition, the pressing jig 100 and the base jig 200 may be spaced apart from each other by a predetermined distance to define a space configured to receive the battery module 300.

The pressing jig 100 may include an additional driving portion configured to move the pressing jig in an upward-downward direction (a z-axis direction), and may be moved downwards so as to come into contact with the battery module 300 mounted to the base jig 200. The surface of the pressing jig 100 that contacts the battery module 300 may be brought into face-to-face contact with the entirety of an upper end surface of the battery module 300.

FIG. 4 is a schematic view of a battery module according to an embodiment of the present invention.

Referring to FIG. 4, the battery module 300 may include a plurality of battery cells 301 and a module housing 320 having formed therein a battery cell receiving portion (not shown) configured to receive the plurality of battery cells 301.

Here, each of the battery cells 301 may be a cylindrical battery cell, which may include a cylindrical battery can (not shown) and an electrode assembly (not shown) received in the battery can.

Here, the battery can may include a material that exhibits high electrical conductivity. For example, the battery can may include a nickel, aluminum, or copper material. An electrode terminal may be formed at each of an upper part and a lower part of the battery can. Specifically, a first electrode terminal (not shown) may be formed at a circular flat upper surface of an upper end of the battery can, and a second electrode terminal (not shown) may be formed at a circular flat lower surface of a lower end of the battery can (not shown) .

In addition, the electrode assembly may be formed so as to have a structure in which a positive electrode and a negative electrode are wound in a jelly-roll shape in the state in which a separator is interposed therebetween. A positive electrode tab may be attached to the positive electrode and may be connected to the first electrode terminal at the upper end of the battery can. A negative electrode tab may be attached to the negative electrode and may be connected to the second electrode terminal at the lower end of the battery can.

In addition, the cylindrical battery cell may be provided at a lower part thereof with a safety element (e.g. a positive temperature coefficient (PTC) element or a TCO), the resistance of which greatly increases to interrupt current when the temperature in the battery cell increases. In addition, the cylindrical battery cell may be provided with a safety vent configured to have a downwardly protruding shape in a normal state and to rupture while protruding so as to exhaust gas when the pressure in the battery increases.

However, various cylindrical battery cells known when the present application was filed may be applied to the battery module 300 according to the present invention, in addition to the cylindrical battery cell described above.

The module housing 320 may include a plurality of battery cell receiving portions configured to receive the plurality of battery cells 301. Each of the battery cell receiving portions may be formed in tight contact with an outer surface of a corresponding one of the battery cells 301 in a horizontal direction so as to wrap the outer surface of the battery cell.

The module housing 320 may include an electrically insulative material, specifically a plastic material.

A first current collection plate 310 and a second current collection plate 330 may be included such that the plurality of battery cells 301 received in the battery cell receiving portions of the module housing 320 are electrically connected to each other.

Here, the first current collection plate 310 may include an electrically conductive material. For example, the electrically conductive material may be copper or aluminum. In addition, the first current collection plate 310 may be configured such that a first connection portion (not shown) formed as the result of protrusion of a part of the first current collection plate and the first electrode terminal (not shown) of each of the battery cells 301 are electrically connected to each other.

The first current collection plate 310 may be loaded at an upper part of the module housing 320 such that the first electrode terminals (not shown) of the plurality of battery cells 301 are electrically connected thereto. At this time, the first connection portion (not shown) of the first current collection plate 310 and the first electrode terminal may be joined to each other by laser welding or resistance welding.

The second current collection plate 330 may include an electrically conductive material. For example, the electrically conductive material may be copper or aluminum. In addition, the second current collection plate 330 may be configured such that a second connection portion (not shown) formed as the result of protrusion of a part of the second current collection plate and the second electrode terminal (not shown) of each of the battery cells 301 are electrically connected to each other.

The second current collection plate 330 may be loaded at a lower part of the module housing 320 such that the second electrode terminals (not shown) of the plurality of battery cells 301 are electrically connected thereto. At this time, the second connection portion (not shown) of the second current collection plate 330 and the second electrode terminal (not shown) may be joined to each other by laser welding or resistance welding.

In the present invention, an adhesive may be added to the entirety of an inner surface of the battery cell receiving portion.

For the adhesive, it is preferable to use at least one selected from the group consisting of mono(meth)acrylate and multifunctional (meth)acrylate as an example of an acrylic-based resin, which is a curable resin; however, the present invention is not limited thereto. The mono (meth) acrylate may be at least one selected from the group consisting of alkyl (meth)acrylate, alkylene (meth)acrylate, and acrylic amide, and the multifunctional (meth)acrylate may be at least one selected from the group consisting of alkyl di(meth)acrylate, alkyl tri(meth)acrylate, alkyl tetra(meth)acrylate, polyether (meth)acrylate, silicone di(meth)acrylate, and urethane di(meth)acrylate.

At least one selected from the group consisting of a cresol novolac epoxy resin, a bisphenol A type epoxy resin, a bisphenol A type novolac epoxy resin, a phenol novolac epoxy resin, a tetrafunctional epoxy resin, a biphenyl type epoxy resin, a triphenol methane type epoxy resin, an alkyl modified triphenol methane epoxy resin, a naphthalene type epoxy resin, a dicyclopentadiene type epoxy resin, a dicyclopentadiene modified phenol type epoxy resin, and a urethane modified epoxy resin may be used as an example of an epoxy-based resin, which is the curable resin; however, the present invention is not limited thereto.

The adhesive may further include a thermal initiator. The thermal initiator may be used to initiate polymerization of the adhesive and to harden the adhesive. In addition, the thermal initiator may be a thermal initiator, well known in the art to which the present invention pertains, which is capable of discharging radicals under a specific temperature condition. For example, an initiator, such as a peroxide-based initiator, an azo-based initiator, or a redox-based initiator, may be used.

The adhesive may be applied to the battery cell receiving portions (not shown) of the module housing 320, and the battery cells 301 may be received in the battery cell receiving portions. Here, the module housing 320 may be preheated to a predetermined temperature.

After the battery cells 301 are received in the battery cell receiving portions (not shown) of the module housing 320, heat may be applied to the adhesive. Specifically, heat may be applied to the adhesive by heating of the thermoelectric device 220.

In addition, the pressing jig 100 may be moved downwards to press the upper end surface of the battery module 300 at a predetermined pressure. As the result of such pressing, a process in which the battery cells 301 are adhered to the interiors of the battery cell receiving portions (not shown) of the module housing 320, to which the adhesive has been added, may be efficiently performed.

After the battery cells 301 are fixed to the module housing 320 by heating through the above high-temperature hardening work, the heating function of the thermoelectric device 220 on the battery module 300 may be changed to the cooling function under the control of the controller (not shown), whereby it is possible to cool the heated battery module 300.

When the battery module is cooled to a predetermined temperature, a final product of the battery module in the state in which the battery cells 301 are stably fixed to the module housing 320 may be completed.

It is possible to provide a battery module manufacturing method using the battery module manufacturing apparatus according to the present invention.

The heat transfer plate is disposed at the upper end surface of the mounting portion (not shown) of the base jig 200, the module housing 320 is located at the upper end of the heat transfer plate, and the adhesive is applied to the battery cell receiving portions (not shown) of the module housing 320. The plurality of battery cells 301 may be inserted into the plurality of battery cell receiving portions, and the first current collection plate 310 and the second current collection plate 330 are electrically connected to the first electrode terminals (not shown) and the second electrode terminals (not shown) of the plurality of battery cells, respectively. The above work may be performed while the temperature of the thermoelectric device 220 is increased. Here, the module housing 320 may have already been preheated.

After the battery cells 301 are received in the battery cell receiving portions (not shown), a high-temperature hardening step in which the exothermic operation is performed at the upper part of the thermoelectric device 220 in order to heat the adhesive applied to the battery cell receiving portions (not shown) such that the adhesive is melted may be performed. The adhesive may be heated at a temperature of 180°C to 220°C for 1 to 60 seconds. After the high-temperature hardening step, a step in which the endothermic operation is performed at the upper part of the thermoelectric device 220 in order to cool the module housing may be performed, whereby manufacture of the battery module may be completed.

Those skilled in the art to which the present invention pertains will appreciate that various applications and modifications are possible within the category of the present invention based on the above description.

### (Description of Reference Numerals)

100: Pressing jig
200: Base jig
201: Base jig frame
210: Thermal pad
220: Thermoelectric device
230: Cooling fin
240: Cooling fan
250: Temperature sensor
300: Battery module
301: Battery cell
310: First current collection plate
320: Module housing
330: Second current collection plate

## Claims

1. A battery module manufacturing apparatus comprising:
a pressing jig (100); and
a base jig (200) located under the pressing jig (100), wherein
the base jig (200) comprises a temperature convertor capable of switching between a heating function and a cooling function, **characterized in that** the temperature convertor comprises a thermoelectric device (220), and
wherein the thermoelectric device (220) is configured to heat or cool a battery module (300) located at an upper end of the base jig (200) by changing a direction in which current is supplied.

2. The battery module manufacturing apparatus according to claim 1, wherein the thermoelectric device is a Peltier element.

3. The battery module manufacturing apparatus according to claim 1, wherein a thermal pad (210) is located at an upper end of the thermoelectric device (220).

4. The battery module manufacturing apparatus according to claim 1, wherein a cooler is located at a lower end of the thermoelectric device (220).

5. The battery module manufacturing apparatus according to claim 4, wherein the cooler comprises a cooling fin (230).

6. The battery module manufacturing apparatus according to claim 5, wherein the cooler comprises one or more cooling fans (240) located at a lower end part of the cooling fin (230).

7. The battery module manufacturing apparatus according to claim 1, wherein a temperature sensor (250) electrically connected to a controller is located at the temperature convertor, and
wherein the controller is configured to control a temperature of the temperature convertor using received temperature data.

8. A battery module manufacturing method using the battery module manufacturing apparatus of any one of claims 1 to 7, the method comprising:
(s1) setting a heat transfer plate on the base jig;
(s2) disposing a module housing at the upper end of the heat transfer plate;
(s3) applying an adhesive to the interior of a battery cell receiving portion of the module housing;
(s4) disposing a battery cell in the battery cell receiving portion and assembling components;
(s5) heating the upper end surface of the base jig to melt the adhesive applied to the interior of the battery receiving portion of the module housing; and
(s6) cooling the upper end surface of the base jig to stably fix the battery cells to the module housing.

9. The battery module manufacturing method according to claim 8, further comprising preheating the module housing in step (s2).

10. The battery module manufacturing method according to claim 8, wherein a direction in which current is supplied to a thermoelectric device located at the base jig is changed to perform the heating in step (s5) and to perform the cooling in step (s6).

11. A battery module produced by the battery module manufacturing method according to any one of claims 8 to 10.

## Patentansprüche

1. Batteriemodul-Herstellungsvorrichtung, umfassend:
ein Presswerkzeug (100); und
ein Basiswerkzeug (200), welches unter dem Presswerkzeug (100) angeordnet ist,
wobei
das Basiswerkzeug (200) einen Temperaturkonverter umfasst, welcher in der Lage ist, zwischen einer Heizfunktion und einer Kühlfunktion umzuschalten,
**dadurch gekennzeichnet, dass** der Temperaturkonverter eine thermoelektrische Vorrichtung (220) umfasst, und
wobei die thermoelektrische Vorrichtung (220) dazu eingerichtet ist, ein Batteriemodul (300), welches an einem oberen Ende des Basiswerkzeugs (200) angeordnet ist, zu heizen oder zu kühlen, indem eine Richtung geändert wird, in welcher ein Strom geliefert wird.

2. Batteriemodul-Herstellungsvorrichtung nach Anspruch 1, wobei die thermoelektrische Vorrichtung ein Peltier-Element ist,

3. Batteriemodul-Herstellungsvorrichtung nach Anspruch 1, wobei ein thermisches Kissen (210) an einem oberen Ende der thermoelektrischen Vorrichtung (220) angeordnet ist.

4. Batteriemodul-Herstellungsvorrichtung nach Anspruch 1, wobei ein Kühler an einem unteren Ende der thermoelektrischen Vorrichtung (220) angeordnet ist.

5. Batteriemodul-Herstellungsvorrichtung nach Anspruch 4, wobei der Kühler eine Kühlrippe (230) umfasst.

6. Batteriemodul-Herstellungsvorrichtung nach Anspruch 5, wobei der Kühler ein oder mehrere Kühlgebläse (240) umfasst, welche an einem unteren Endteil der Kühlrippe (230) angeordnet sind.

7. Batteriemodul-Herstellungsvorrichtung nach Anspruch 1, wobei ein Temperatursensor (250), welcher mit einer Steuereinheit elektrisch verbunden ist, an dem Temperaturkonverter angeordnet ist, und
wobei die Steuereinheit dazu eingerichtet ist, eine Temperatur des Temperaturkonverters unter Verwendung von erhaltenen Temperaturdaten zu steuern.

8. Batteriemodul-Herstellungsverfahren unter Verwendung der Batteriemodul-Herstellungsvorrichtung nach einem der Ansprüche 1 bis 7, das Verfahren umfassend:
(s1) Setzen einer Wärmetransfer-Platte auf das Basiswerkzeug;
(s2) Anordnen eines Modulgehäuses an dem oberen Ende der Wärmetransfer-Platte;
(s3) Aufbringen eines Haftmittels auf das Innere eines Batteriezellen-Aufnahmeabschnitts in dem Modulgehäuse;
(s4) Anordnen einer Batteriezelle in dem Batteriezellen-Aufnahmeabschnitt und Zusammenfügen von Komponenten;
(s5) Heizen der oberen Endfläche des Basiswerkzeugs, um das Haftmittel zu schmelzen, welches auf das Innere des Batterie-Aufnahmeabschnitts des Modulgehäuses aufgebracht wird; und
(s6) Kühlen der oberen Endfläche des Basiswerkzeugs, um die Batteriezellen stabil an dem Modulgehäuse zu fixieren.

9. Batteriemodul-Herstellungsverfahren nach Anspruch 8, ferner umfassend ein Vorheizen des Modulgehäuses in Schritt (s2).

10. Batteriemodul-Herstellungsverfahren nach Anspruch 8, wobei eine Richtung, in welcher Strom zu einer thermoelektrischen Vorrichtung geliefert wird, welche an dem Basiswerkzeug angeordnet ist, geändert wird, um das Heizen in Schritt (s5) durchzuführen und das Kühlen in Schritt (s6) durchzuführen.

11. Batteriemodul, welches durch das Batteriemodul-Herstellungsverfahren nach einem der Ansprüche 8 bis 10 hergestellt ist.

## Revendications

1. Appareil de fabrication de module de batterie comprenant :
un gabarit de pressage (100) ; et
un gabarit de base (200) situé sous le gabarit de pressage (100), dans lequel le gabarit de base (200) comprend un convertisseur de température capable de commuter entre une fonction de chauffage et une fonction de refroidissement, **caractérisé en ce que** le convertisseur de température comprend un dispositif thermoélectrique (220), et
dans lequel le dispositif thermoélectrique (220) est configuré pour chauffer ou refroidir un module de batterie (300) situé à une extrémité supérieure du gabarit de base (200) en modifiant une direction dans laquelle un courant est fourni.

2. Appareil de fabrication de module de batterie selon la revendication 1, dans lequel le dispositif thermoélectrique est un élément Peltier.

3. Appareil de fabrication de module de batterie selon la revendication 1, dans lequel un tampon thermique (210) est situé à une extrémité supérieure du dispositif thermoélectrique (220).

4. Appareil de fabrication de module de batterie selon la revendication 1, dans lequel un refroidisseur est situé à une extrémité inférieure du dispositif thermoélectrique (220).

5. Appareil de fabrication de module de batterie selon la revendication 4, dans lequel le refroidisseur comprend une ailette de refroidissement (230).

6. Appareil de fabrication de module de batterie selon la revendication 5, dans lequel le refroidisseur comprend un ou plusieurs ventilateurs de refroidissement (240) situés au niveau d'une partie d'extrémité inférieure de l'ailette de refroidissement (230).

7. Appareil de fabrication de module de batterie selon la revendication 1, dans lequel un capteur de température (250) connecté électriquement à un dispositif de commande est situé au niveau du convertisseur de température, et
dans lequel le dispositif de commande est configuré pour commander une température du convertisseur de température à l'aide de données de température reçues.

8. Procédé de fabrication de module de batterie utilisant l'appareil de fabrication de module de batterie selon l'une quelconque des revendications 1 à 7, le procédé comprenant :
(s1) le placement d'une plaque de transfert de chaleur sur le gabarit de base ;
(s2) la disposition d'un boîtier de module à l'extrémité supérieure de la plaque de transfert de chaleur ;
(s3) l'application d'un adhésif sur l'intérieur d'une portion de réception d'élément de batterie du boîtier de module ;
(s4) la disposition d'un élément de batterie dans la portion de réception d'élément de batterie et l'assemblage de constituants ;
(s5) le chauffage de la surface d'extrémité supérieure du gabarit de base pour faire fondre l'adhésif appliqué sur l'intérieur de la portion de réception de batterie du boîtier de module ; et
(s6) le refroidissement de la surface d'extrémité supérieure du gabarit de base pour fixer de manière stable les éléments de batterie au boîtier de module.

9. Procédé de fabrication de module de batterie selon la revendication 8, comprenant en outre le préchauffage du boîtier de module à l'étape (s2).

10. Procédé de fabrication de module de batterie selon la revendication 8, dans lequel une direction dans laquelle un courant est fourni à un dispositif thermoélectrique situé au niveau du gabarit de base est modifiée pour réaliser le chauffage à l'étape (s5) et pour réaliser le refroidissement à l'étape (s6).

11. Module de batterie produit par le procédé de fabrication de module de batterie selon l'une quelconque des revendications 8 à 10.
